# EUROPEAN PATENT APPLICATION

(11) **EP 2 911 267 A1**
(43) Date of publication of application: **26.08.2015**
(21) Application number: 15150812.4
(22) Date of filing: 12.01.2015
(51) Int. Cl.: H02J 7/00, G01R 31/36, G01R 19/165, H01M 10/48, H02H 7/18

(54) **Battery management system**

(30) Priority: 10.02.2014 KR 20140015115
(71) Applicant: Samsung SDI Co., Ltd., Yongin-si, Gyeonggi-do (KR)
(72) Inventor: Jang, Jin-Soo, Yongin-si, Gyeonggi-do (KR); Gu, Jae-Sung, Yongin-si, Gyeonggi-do (KR)
(74) Representative: Niepelt, Carsten

(57) **Abstract**

The present invention relates to a battery management system (BMS).

The present invention includes: a battery pack (10) including a plurality of battery cells (C1,...Cn); a first outer terminal (P1) and a second outer terminal (P2) that connect the battery pack (10) to a load; a redundant resistive element (40, 50, 60) disposed between a first output terminal (O1) of the battery pack and the first outer terminal (P1); a resistive element (20) disposed between a second output terminal (O2) of the battery pack and the second output terminal (P2); and a controller (80) that detects an overcurrent flowing through the battery pack (10) by using the redundant resistive element (40, 50, 60) and the resistive element (20).

## Description

### BACKGROUND

### (a) Field of the Invention

The present invention relates to a battery management system (BMS).

### (b) Description of the Related Art

In general, a rechargeable battery is capable of being repeatedly charged and discharged, and a nickel-metal hydride (Ni-MH) battery, a lithium (Li) ion battery, etc. are used as the rechargeable battery. The rechargeable battery is used as a power source for a mobile device, an electric vehicle, a hybrid vehicle, an electrical device, etc. and can be used in various ways depending on device types to which it is applicable.

A low-capacity rechargeable battery is used in small portable electronic devices such as mobile phones, notebook computers, and camcorders, while a high-capacity rechargeable battery is widely used as a power source for driving a motor of a hybrid vehicle, etc.

Such a rechargeable battery forms a battery pack along with a battery management system (BMS) for controlling charging and discharging, and is charged and discharged through an outer terminal of the battery pack.

In general, the BMS measures a current that flows through the battery pack by using a shunt resistor that is disposed between the battery pack and the outer terminal.

The BMS converts a voltage applied between opposite ends of the shunt resistor into a current to determine whether an overcurrent flows or not.

Since there is a high risk of explosion if the overcurrent flows through the battery pack, it is crucial to measure the current that flows through the battery pack.

However, if an abnormality occurs in the shunt resistor itself, it is impossible to measure the current that flows through the battery pack.

Accordingly, in addition to the shunt resistor, a current sensor including a Hall element is added to measure the current that flows through the battery pack.

Such a measuring method involves an overall weight and volume increase of the battery pack, and the cost is increased due to additional parts.

### SUMMARY

An exemplary embodiment provides a battery management system (BMS) that is capable of measuring an overcurrent of a battery pack without additional parts.

The BMS according to an exemplary embodiment includes: a battery pack including a plurality of battery cells; a first outer terminal and a second outer terminal that connect the battery pack to a load; a redundant resistive element disposed between a first output terminal of the battery pack and the first outer terminal; a resistive element disposed between a second output terminal of the battery pack and the second output terminal; and a controller that detects an overcurrent flowing through the battery pack by using the redundant resistive element and the resistive element.

The redundant resistive element may include a bus bar and a relay that are connected in series between the first output terminal and the first outer terminal.

The redundant resistive element may further include a bus bar and a fuse that are connected in series between the first output terminal and the first outer terminal.

The BMS may further include a current detector that calculates a first charge/discharge current flowing through the resistive element by using resistance of the resistive element and a voltage between opposite ends of the resistive element.

The controller may calculate a second charge/discharge current that flows through the redundant resistive element by using resistance of the redundant resistive element and the voltage between opposite ends of the redundant resistive element, and may determine an abnormality of the resistive element by comparing the first and second charge/discharge currents.

The controller may detect an overcurrent that flows through the battery pack by using the second charge/discharge current if the abnormality occurs in the resistive element.

The BMS may further include an amplifier that amplifies a voltage between opposite ends of the redundant resistive element.

The first output terminal may be connected to a positive electrode terminal of the battery pack, while the second output terminal may be connected to a negative electrode terminal of the battery pack.

A BMS according to an exemplary embodiment includes: a battery pack including a plurality of battery cells; a first outer terminal and a second outer terminal that connect the battery pack to a load; a first resistive element that is disposed between a negative electrode terminal of the battery pack and the second outer terminal; a bus bar and a second resistive element that are disposed between a positive electrode terminal of the battery pack and the first outer terminal; and a controller that detects an overcurrent that flows through the battery pack by using a first charge/discharge current flowing through the first resistive element and a second charge/discharge current flowing through the bus bar and the second resistive element.

The second resistive element may include a relay that is connected in series with the bus bar.

The second resistive element may include a fuse that is connected in series with the bus bar.

The BMS may include a current detector that detects a voltage between opposite ends of the first resistive element and then calculates a first charge/discharge current by using resistance of the first resistive element and the voltage between opposite ends of the first resistive element.

The BMS may include an amplifier that amplifies a voltage between opposite ends of the bus bar and the second resistive element.

The controller may calculate a second charge/discharge current by using resistances of the bus bar and the second resistive element and the voltage that is outputted from the amplifier, and may then detect an overcurrent of the battery pack depending on either one of the first and second charge/discharge currents.

The controller may detect an overcurrent of the battery pack by using the first charge/discharge current if a difference between the first and second charge/discharge currents falls within a predetermined range, and may detect an overcurrent of the battery pack by using the second charge/discharge current if a difference between the first and second charge/discharge currents exceeds the predetermined range.

The controller may disconnect the battery pack from the first and second outer terminals if an overcurrent flows through the battery pack.

The exemplary embodiment can measure the overcurrent by using the bus bar and the resistive element that are disposed between the battery pack and the outer terminal even if an abnormality occurs in a shunt resistor.

A method of managing a battery system with a battery pack including a plurality of battery cells, a first outer terminal and a second outer terminal that connect the battery pack to a load, a resistive element disposed between a second output terminal of the battery pack and the second outer terminal and a redundant resistive element disposed between a first output terminal of the battery pack and the first outer terminal, comprises detecting an overcurrent that flows through the battery pack with a controller by using a first charge/discharge current flowing through the resistive element and a second charge/discharge current flowing through the redundant resistive element.

The method may further comprise the steps of a detecting a voltage between opposite ends of the resistive element with a current detector and then calculating the first charge/discharge current by using resistance of the resistive element and the voltage between opposite ends of the resistive element.

The method may further comprise the steps of calculating the second charge/discharge current by using resistance of the redundant resistive element and the voltage between opposite ends of the redundant resistive element and then determining an abnormality of the resistive element by comparing the first and second charge/discharge currents by the controller.

The method may further comprise the step of amplifying a voltage between opposite ends of the redundant resistive element by an amplifier.

In the method, an overcurrent of the battery pack may be detected by the controller by using the first charge/discharge current if a difference between the first and second charge/discharge currents falls within a predetermined range, and an overcurrent of the battery pack may be detected by the controller by using the second charge/discharge current if a difference between the first and second charge/discharge currents exceeds the predetermined range.

In the method, the battery pack may be disconnected by the controller from the first and second outer terminals if an overcurrent flows through the battery pack.

In the method, an overcurrent that flows through the battery pack may be detected by the controller by using the second charge/discharge current if the abnormality occurs in the resistive element.

### BRIEF DESCRIPTION OF THE DRAWING

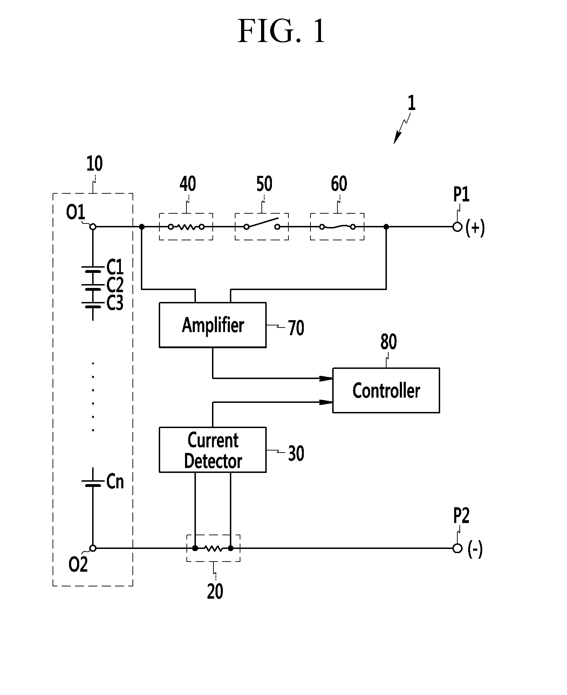

FIG. 1 is a drawing of a battery management system (BMS) according to an exemplary embodiment of the present invention.

### DETAILED DESCRIPTION

In the following detailed description, only certain exemplary embodiments of the present invention have been shown and described, simply by way of illustration.

The drawings and description are to be regarded as illustrative in nature and not restrictive.

Like reference numerals designate like elements throughout the specification.

Throughout this specification and the claims that follow, when it is described that an element is "coupled" to another element, the element may be "directly coupled" to the other element or "electrically coupled" to the other element through a third element.

In addition, unless explicitly described to the contrary, the word "comprise" and variations such as "comprises" or "comprising" will be understood to imply the inclusion of stated elements but not the exclusion of any other elements.

The present invention will be described more fully hereinafter with reference to the accompanying drawing, in which exemplary embodiments of the invention may be easily embodied by those skilled in the art.

FIG. 1 is a drawing of a battery management system (BMS) according to an exemplary embodiment of the present invention.

Referring to FIG. 1, the BMS 1 according to the exemplary embodiment includes a battery pack 10, a shunt resistor 20, a current detector 30, a bus bar 40, a relay 50, a fuse 60, an amplifier 70, a controller 80, a first outer terminal P1, and a second outer terminal P2.

The battery pack 10 includes a plurality of battery cells C1 to Cn, a first output terminal O1, and a second output terminal 02.

The plurality of battery cells C1 to Cn may respectively have a structure including: an electrode assembly including a positive electrode plate and a negative electrode plate while interposing a separator there between and being disposed at respective lateral sides thereof; a case for accommodating the electrode assembly; a positive electrode terminal electrically connected to the positive electrode plate; and a negative electrode terminal electrically connected to the negative electrode plate.

The battery cells C1 to Cn may each be a lithium-ion secondary battery, a lithium polymer battery, etc.

The positive electrode terminal of the battery pack 10 is connected to the first output terminal O1, while the negative electrode terminal is connected to the second output terminal 02.

The first and second output terminals O1 and O2 of the battery pack 10 are electrically connected to the first and second outer terminals P1 and P2, respectively, and are connected to an external load through the first and second outer terminals P1 and P2 (not shown).

In this case, the external load may include a charger, a motor, etc.

The battery pack 10 according to the present exemplary embodiment can be used in an electric vehicle, an electric bike, etc.

The shunt resistor 20 is disposed on a high current path between the second output electrode 02 of the battery pack 10 and the second outer terminal P2, and has a fixed resistance.

The current detector 30 detects a first charge/discharge current that flows through the shunt resistor 20, and transmits it to the controller 80.

In this case, the current detector 30 may calculate the first charge/discharge current by using the resistance of the shunt resistor 20 and a voltage between opposite ends of the shunt resistor 20.

The bus bar 40, the relay 50, and the fuse 60 according to the exemplary embodiment are disposed on the high current path between the first output terminal O1 and the first outer terminal P1 such that they are connected to each other in series.

The bus bar 40, the relay 50, and the fuse 60, as resistive elements respectively having predetermined internal resistances, and act as a redundant resistive element along with the shunt resistor 20 when measuring the current that flows in the high current path.

In the present exemplary embodiment of the present invention, the bus bar 40, the relay 50, and the fuse 60 are all used as resistive elements, but the present invention is not limited thereto, and at least one of the relay 50 and the fuse 60 may be omitted.

Further, the bus bar 40, the relay 50, and the fuse 60 may be connected in different sequences.

The bus bar 40 electrically connects the first output terminal O1 with the first outer terminal P1.

The bus bar 40 may be made of a conductive material.

The relay 50 is controlled by the controller 80 to selectively connect the first output terminal O1 of the battery pack 10 with the first outer terminal P1.

The fuse 60 is melted to cut off the high current path if a large amount of current exceeding a predetermined level flows between the first output terminal O1 of the battery pack 10 and the first outer terminal P1.

The amplifier 70 amplifies a voltage between opposite ends of the bus bar 40, the relay 50, and the fuse 60, and transmits it to the controller 80.

Meanwhile, the present exemplary embodiment is not limited thereto, and if the BMS 1 has a configuration in which one of the relay 50 and the fuse 60 is omitted, the amplifier 70 may amplify a voltage between the opposite ends of the bus bar 40 and the relay 50 or a voltage between the opposite ends of the bus bar 40 and the fuse 60 so as to transmit it to the controller 80.

The controller 80 calculates a second charge/discharge current that flows through the bus bar 40, the relay 50, and the fuse 60 by using the voltage between the opposite ends of the bus bar 40, the relay 50, and the fuse 60, which is amplified by the amplifier 70, and respective resistances of the bus bar 40, the relay 50, and the fuse 60.

Subsequently, the controller 80 determines an abnormality of the shunt resistor 20 by comparing the first charge/discharge current with the second charge/discharge current.

In detail, the controller 80 may determine the abnormality of the shunt resistor 20 depending on whether a difference between the first and second charge/discharge currents falls within a predetermined range.

For example, the controller 80 determines that the shunt resistor 20 is in a normal state if the difference between the first and second charge/discharge currents falls within the predetermined range, and may then detect whether the overcurrent flows through the battery pack 10 or not by the first charge/discharge current that flows through the shunt resistor 20.

On the contrary, the controller 80 determines that the shunt resistor 20 is in an abnormal state if the difference between the first and second charge/discharge currents exceeds the predetermined range, and may then detect whether the overcurrent flows through the battery pack 10 or not by the second charge/discharge current that flows through the bus bar 40, the relay 50, and the fuse 60.

If the shunt resistor 20 is in the normal state, the controller 80 determines whether the first charge/discharge current exceeds the predetermined level, and if it does, determines that the overcurrent flows through the battery pack 10.

Similarly, if the shunt resistor 20 is in the abnormal state, the controller 80 determines whether the second charge/discharge current exceeds the predetermined level, and if it does, determines that the overcurrent flows through the battery pack 10.

The controller 80 electrically disconnects the battery pack 10 from the first and second outer terminals P1 and P2 if the overcurrent flows through the battery pack 10.

For example, the controller 80 may electrically disconnect the first output terminal O1 of the battery pack 10 from the first outer terminal P1 through the relay 50.

Further, if the shunt resistor 20 is in the abnormal state, the controller 80 may request replacement of the shunt resistor 20 to a user through an external interface (not shown).

That is, the controller 80 according to the exemplary embodiment may use the bus bar 40, the relay 50, and the fuse 60 as the redundant resistive element instead of the shunt resistor 20 so as to measure the charge/discharge current that flows through the battery pack 10, such that it can detect the overcurrent flowing through the battery pack 10 even if the abnormality occurs in the shunt resistor 20.

## Claims

1. A battery management system (1) comprising:
a battery pack (10) including a plurality of battery cells (C1, ..., Cn);
a first outer terminal (P1) and a second outer terminal (P2) that connect the battery pack (10) with a load;
a redundant resistive element disposed between a first output terminal (O1) of the battery pack (10) and the first outer terminal (P1);
a resistive element (20) disposed between a second output terminal (02) of the battery pack (10) and the second output terminal (P2); and
a controller (80) adapted to detect an overcurrent flowing through the battery pack (10) by using the redundant resistive element and the resistive element (20).

2. The battery management system of claim 1, wherein the redundant resistive element includes a bus bar (40) and a relay (50) or a bus bar (40) and a fuse (60) that are connected in series between the first output terminal (O1) and the first outer terminal (P1).

3. The battery management system of claim 1, wherein the redundant resistive element includes a relay (50) or a fuse (60) disposed with a bus bar (40) between the first output terminal (O1) and the first outer terminal (P1).

4. The battery management system of one of claims 1 to 3, further comprising a current detector (30) adapted to calculate a first charge/discharge current flowing through the resistive element (20) by using resistance of the resistive element (20) and a voltage between opposite ends of the resistive element (20).

5. The battery management system of claim 4, wherein the controller (80) is adapted to calculate a second charge/discharge current that flows through the redundant resistive element by using resistance of the redundant resistive element and the voltage between opposite ends of the redundant resistive element and to determine an abnormality of the resistive element by comparing the first and second charge/discharge currents.

6. The battery management system of claim 5, wherein the controller (80) is adapted to detect an overcurrent that flows through the battery pack (10) by using the second charge/discharge current if the abnormality occurs in the resistive element (20).

7. The battery management system of one of claims 1 to 6, further comprising an amplifier (70) adapted to amplify a voltage between opposite ends of the redundant resistive element.

8. The battery management system of one of claims 1 to 7, wherein the first output terminal (O1) is connected to a positive electrode terminal of the battery pack (10), while the second output terminal (02) is connected to a negative electrode terminal of the battery pack (10).

9. A method of managing a battery system (10) with a battery pack (10) including a plurality of battery cells (C1, ..., Cn), a first outer terminal (P1) and a second outer terminal (P2) that connect the battery pack (10) to a load, a resistive element (20) disposed between a second output terminal (02) of the battery pack (10) and the second outer terminal (P2) and a redundant resistive element disposed between a first output terminal (O1) of the battery pack (10) and the first outer terminal (P1), comprising the step of:
detecting an overcurrent that flows through the battery pack (10) with a controller (80) by using a first charge/discharge current flowing through the resistive element (20) and a second charge/discharge current flowing through the redundant resistive element.

10. The method of claim 9, further comprising the steps of a detecting a voltage between opposite ends of the resistive element (20) with a current detector (30) and then calculating the first charge/discharge current by using resistance of the resistive element (20) and the voltage between opposite ends of the resistive element (20).

11. The method of claim 10, further comprising the steps of calculating the second charge/discharge current by using resistance of the redundant resistive element and the voltage between opposite ends of the redundant resistive element and then determining an abnormality of the resistive element by comparing the first and second charge/discharge currents by the controller (80).

12. The method of one of claims 9 to 11, further comprising the step of amplifying a voltage between opposite ends of the redundant resistive element by an amplifier (30).

13. The method of claim 11 or 12, wherein an overcurrent of the battery pack (10) is detected by the controller (80) by using the first charge/discharge current if a difference between the first and second charge/discharge currents falls within a predetermined range, and wherein an overcurrent of the battery pack (10) is detected by the controller (80) by using the second charge/discharge current if a difference between the first and second charge/discharge currents exceeds the predetermined range.

14. The method of claim 14, wherein the battery pack (10) is disconnected by the controller (80) from the first and second outer terminals (P1, P2) if an overcurrent flows through the battery pack (10).

15. The method of one of claims 9 to 14, wherein an overcurrent that flows through the battery pack (10) is detected by the controller (80) by using the second charge/discharge current if the abnormality occurs in the resistive element (20).
